Europäisches Patentamt

European Patent Office

Office européen des brevets

(11) Numéro de publication: **0 165 863**

**A1**

(12) # DEMANDE DE BREVET EUROPEEN

(21) Numéro de dépôt: **85401175.6**

(22) Date de dépôt: **13.06.85**

(51) Int. Cl.⁴: **H 01 L 21/84**
**H 01 L 29/78**

(30) Priorité: **22.06.84 FR 8409875**

(43) Date de publication de la demande:
**27.12.85 Bulletin 85/52**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Szydlo, Nicolas**
**THOMSON-CSF SCPI 173, bld Haussmann**
**F-75379 Paris Cedex 08(FR)**

(72) Inventeur: **Boulitrop, François**
**THOMSON-CSF SCPI 173, bld Haussmann**
**F-75379 Paris Cedex 08(FR)**

(72) Inventeur: **Kasprazak, Rolande**
**THOMSON-CSF SCPI 173, bld Haussmann**
**F-75379 Paris Cedex 08(FR)**

(74) Mandataire: **Lepercque, Jean et al,**
**THOMSON-CSF SCPI 173, Bld Haussmann**
**F-75379 Paris Cedex 08(FR)**

(54) Procédé de fabrication d'au moins un transistor à effet de champ, en couche mince, et transistor obtenu par ce procédé.

(57) L'invention concerne un procédé de fabrication de transistors à effet de champ de type coplanaire et auto-aligné, obtenus en couche mince sur un substrat isolant (1).

Le procédé permet, grâce à des techniques d'auto-alignement des électrodes (61, 91, 92) et d'implantation ionique, de n'utiliser que trois niveaux de masquage.

L'invention s'applique au domaine de la microélectronique en grande surface et en particulier à la commande et à l'adressage d'un écran plat à cristal liquide ou d'un capteur d'images.

FIG_15

# PROCEDE DE FABRICATION D'AU MOINS UN TRANSISTOR A EFFET DE CHAMP, EN COUCHE MINCE, ET TRANSISTOR OBTENU PAR CE PROCEDE

La présente invention concerne un procédé de fabrication d'un transistor à effet de champ, coplanaire et auto-aligné. Le procédé met en oeuvre trois niveaux de masquage et utilise un semiconducteur en couche mince. Il s'applique au domaine de la microélectronique en grande surface et en particulier à la commande et à l'adressage d'un écran plat à cristal liquide ou d'un capteur d'images.

Actuellement, le semiconducteur en couche mince le mieux adapté aux dispositifs en grande surface est le silicium amorphe hydrogéné. Ceci est dû à la faible température de dépôt du semiconducteur qui rend possible l'utilisation de substrats transparents et économiques tels que le verre et également à l'homogénéité de la couche déposée, même sur de grandes surfaces. Cependant, l'utilisation de ce matériau impose quatre contraintes principales qu'il est nécessaire de respecter afin d'obtenir des dispositifs ayant des performances optimales.

Première contrainte, les dépôts des couches de semiconducteur et d'isolant de grille doivent être réalisés dans la foulée et dans la même enceinte afin de préserver une bonne qualité de l'interface semiconducteur-isolant. Dans le cas du silicium amorphe hydrogéné (a - Si : H) ceci est généralement respecté car les dispositifs utilisés pour déposer le a - Si : H permettent également le dépôt de l'isolant de grille sans altérer la propreté du premier dépôt.

Deuxième contrainte de fabrication, la nécessité de disposer de bons contacts source et drain impose l'utilisation d'une couche de silicium amorphe hydrogéné qui soit fortement dopée en contact avec les électrodes de source et de drain. Des contacts source et drain de bonne qualité peuvent être obtenus au moyen d'une couche intermédiaire de a - Si : H dopé durant le dépôt par addition d'un gaz supplémentaire contenant un élément dopant ou au moyen de l'implantation ionique.

Troisième contrainte de fabrication, en raison de la faible conductivité du silicium amorphe hydrogéné, les distances entre le canal et les contacts source d'une part et drain d'autre part doivent être minimales. Les contacts de source et de drain ainsi que la grille doivent être définis de manière précise (auto-alignement des électrodes) afin de réduire les capacités parasites se présentant à travers l'isolant de grille. Les contacts de source et de drain ainsi que la grille doivent être situés du même côté de la couche de semiconducteur afin de supprimer la résistance d'accès à travers l'épaisseur de ladite couche. Dans la majorité des transistors en couche mince fabriqués actuellement, la grille et les contacts de source et de drain se recouvrent partiellement et sont placés de part et d'autre de la couche de a - Si : H. Il est apparu récemment une méthode d'auto-alignement permettant la réalisation de transistors en couche mince en configuration dite "staggered" dans la terminologie anglo-saxonne (c'est-à-dire présentant la succession : substrat-grille-isolant-semiconducteur-contacts de drain et de source). Cette méthode a fait l'objet d'un article intitulé "A self-alignment processed a - Si TFT matrix circuit for LCD panels" par ASAMA et al dans la revue SID 83 Digest, pages 144 et 145. La découpe des contacts source et drain dans la couche de a - Si : H dopée n est réalisée par une insolation depuis le substrat ce qui permet à la grille de servir de masque. Cette technique n'est applicable qu'à ce type de structure dans laquelle grille et contacts sont de part et d'autre de la couche de a - Si : H qui doit être suffisamment mince pour être transparente.

La quatrième contrainte de réalisation est constituée par le nombre de niveaux de masquage. Quatre niveaux de masquage sont généralement utilisés pour la fabrication des transistors en couche mince en a - Si : H. Trois niveaux suffisent au procédé auto-aligné. Pour augmenter le rendement de fabrication et en diminuer le coût, il est nécessaire de limiter le nombre des niveaux de masquage au strict minimum.

A ce jour, aucun des procédés connus ne permet de satisfaire les quatre contraintes énumérées ci-dessus. Le procédé de fabrication selon l'invention satisfait ces contraintes par des techniques d'auto-alignement et d'implantation ionique. Il permet de réduire à trois le nombre des niveaux de masquage.

L'invention a donc pour objet un procédé de fabrication d'au moins un transistor à effet de champ, en couche mince, de type coplanaire et à auto-alignement des électrodes, caractérisé en ce que le procédé comprend les huit étapes suivantes :

- première étape : dépôts successifs sur un substrat d'une couche semiconductrice et d'une couche d'isolant de grille,

- deuxième étape : formation de mésas par un premier jeu de masques de résine et par attaque des couches d'isolant de grille et semiconductrice jusqu'au niveau du substrat, chacune des mésas étant destinée à la formation d'un transistor,

- troisième étape : dépôt d'une couche d'isolant de passivation et mise à nu de l'isolant de grille par retrait de la résine,

- quatrième étape : dépôt des électrodes de grille des transistors par un deuxième jeu de masques de résine et photolithographie,

- cinquième étape : attaque de la couche d'isolant de grille non recouverte par les électrodes de grille jusqu'à mise à nu de la couche semiconductrice,

- sixième étape : obtention de contacts ohmiques de source et de drain par implantation ionique,

- septième étape : élimination de la résine de protection de grille suivie d'une activation des ions implantés à l'étape précédente,

- huitième étape : dépôt des électrodes de source et de drain par un troisième jeu de masques de résine et retrait de la résine.

L'invention a aussi pour objet un transistor à effet de champ en couche mince, de type coplanaire et à électrodes auto-alignées réalisé sur un substrat isolant, caractérisé en ce qu'il est obtenu par le procédé de fabrication exposé ci-dessus.

L'invention sera mieux comprise et d'autres avantages apparaîtront à la lecture de la description qui va suivre et d'après les figures annexées parmi lesquelles :

- la figure 1 illustre la première étape du procédé selon l'invention,

- les figures 2 et 3 illustrent la seconde étape du procédé,

- les figures 4 et 5 illustrent la troisième étape du procédé,

- les figures 6 à 9 illustrent la quatrième étape du procédé,

- les figures 10 et 11 illustrent la cinquième étape du procédé,

- la figure 12 illustre la sixième étape du procédé,

- la figure 13 illustre la septième étape du procédé,

- les figures 14 à 16 illustrent la huitième étape du procédé.

La description va porter, à titre d'exemple, sur un procédé de fabrication de transistors en couche mince (TFT) réalisés sur a - Si : H sur un substrat faisant partie d'un écran de visualisation à cristal liquide. Ces transistors sont alors destinés à l'adressage et à la commande intégrée de dispositifs en grande surface. Le procédé selon l'invention est également applicable à d'autres semiconducteurs amorphes ou polycristallins déposés en couche mince.

Le procédé selon l'invention est un procédé collectif de fabrication. Par souci de simplification, les dessins ne montreront que la fabrication d'un transistor.

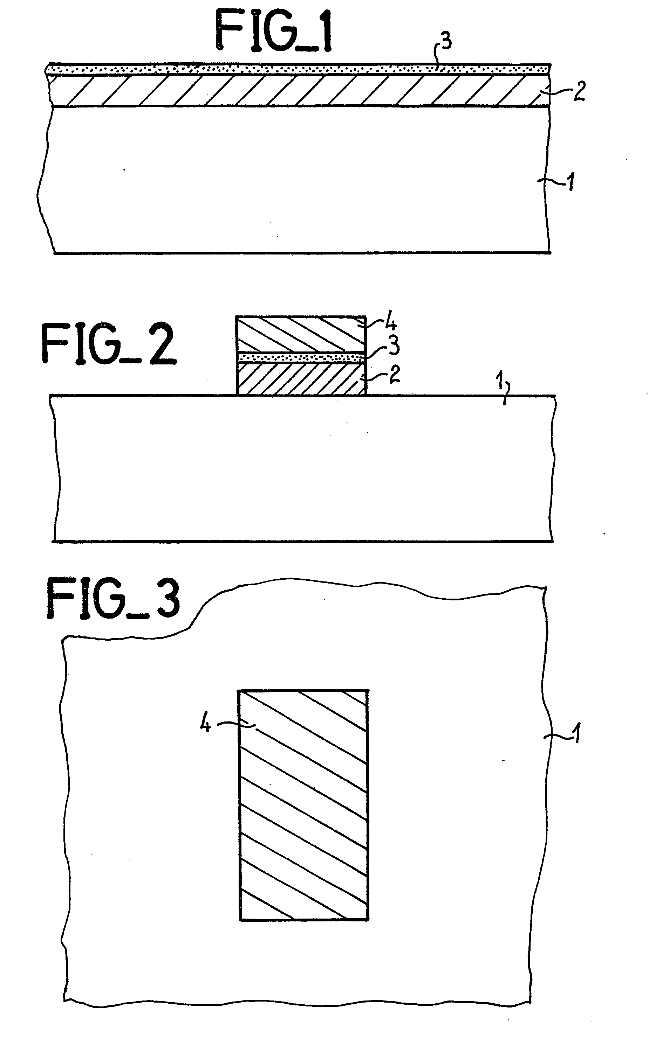

La figure 1 est illustrative de la première étape du procédé de fabrication selon l'invention. Cette étape consiste à déposer sur un substrat transparent 1, une couche 2 de silicium amorphe hydrogéné a - Si : H, puis une couche d'isolant 3. Si le substrat est en verre, les méthodes de dépôt doivent être réalisées à une température qui n'altère pas ses propriétés. Pour le semiconducteur, une température de dépôt de l'ordre de 200 à 300° C peut être obtenue par une méthode de dépôt en phase gazeuse par décharge luminescente. L'hydrogénation résulte d'une incorporation pendant le dépôt selon une méthode connue. La couche d'isolant 3 est déposée dans la foulée de la couche 2 par le même procédé de décomposition plasma de gaz dont la nature dépend de l'espèce isolante que l'on veut obtenir. Par exemple, si l'isolant 3 est du nitrure de silicium $Si_3 N_4$ on procédera à la décomposition d'un mélange de silane $Si H_4$ et de gaz ammoniac $NH_3$. Des isolants tels que l'oxyde de silicium $SiO_2$ et l'oxynitrure de silicium SiON peuvent également convenir. La température de dépôt de la couche 3 ne doit pas être supérieure à la température de dépôt de la couche de a - Si : H afin que l'hydrogène ne quitte pas cette couche. Typiquement, les épaisseurs des dépôts sont de l'ordre de 0,2 à 0,5 μm pour la couche 2 de a - Si : H et de 0,1 à 0,2 μm pour la couche d'isolant.

Les figures 2 et 3 sont illustratives de la seconde étape du procédé. La figure 2 est une vue de face correspondant à la figure 1 et la figure 3 est une vue de dessus. Cette seconde étape est constituée par le premier niveau de masquage servant à délimiter les mésas sur lesquelles seront élaborés les transistors. La manière de procéder est connue : protection par une couche 4 de résine des parties à conserver (une mésa par futur transistor) et attaque de la partie à éliminer par voie chimique ou sèche (plasma). On obtient ainsi sur le substrat 1 la superposition des trois couches : semiconducteur 2 - isolant 3 - résine 4. Les dimensions des mésas dépendront de l'intensité du courant que devra supporter chaque transistor. Un ordre de grandeur possible, pour le type d'utilisation proposé, est d'environ 30 $\mu$m sur 100 $\mu$m.

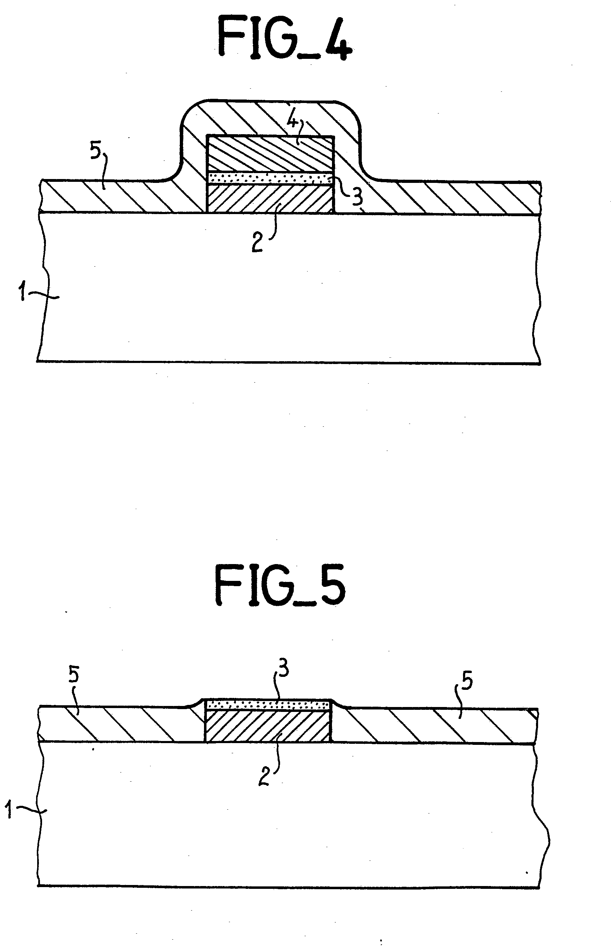

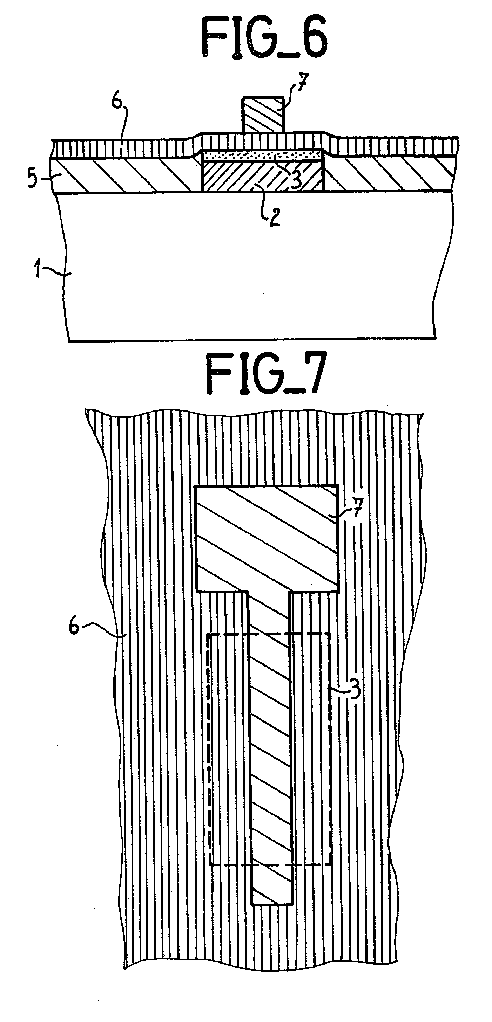

Les figures 4 et 5 sont illustratives de la troisième étape du procédé qui consiste à déposer un isolant de passivation des flancs de la mésa afin d'éviter les court-circuits entre source ou drain d'une part et grille d'autre part. Comme représenté à la figure 4, une couche 5 d'isolant est déposée par l'une des méthodes de dépôt citées. L'isolant peut être de l'oxyde de silicium $Si O_2$, du nitrure de silicium $Si_3 N_4$ ou un autre isolant. La couche d'isolant de passivation peut avoir 0,5 $\mu$m d'épaisseur. Par la méthode dite de lift-off, les éléments de résine 4 restant de la seconde étape sont éliminés ce qui a pour objet de faire réapparaître l'isolant de grille déposé au cours de la première étape, comme l'indique la figure 5.

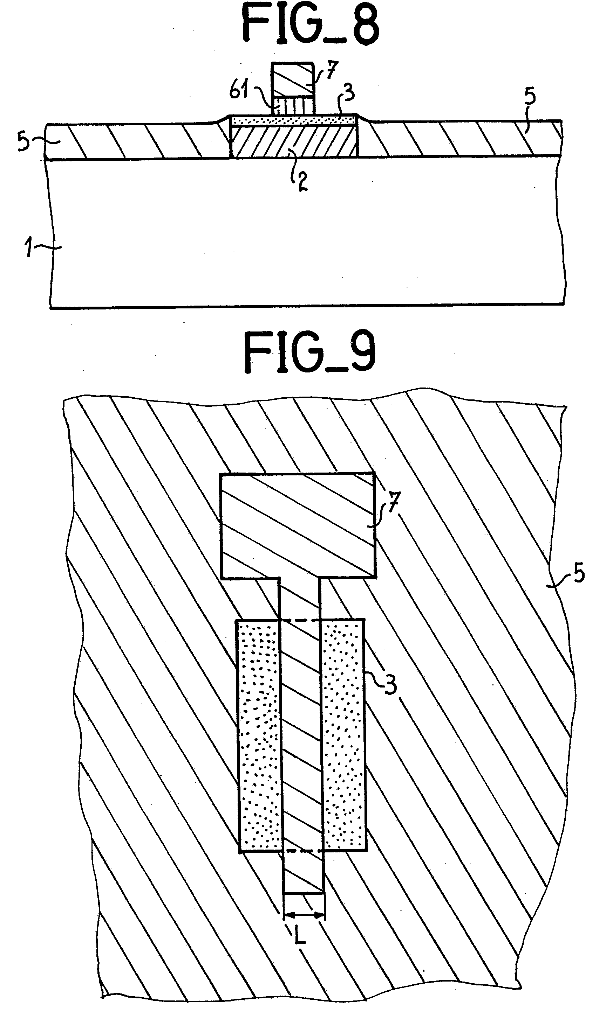

La quatrième étape consiste à déposer le métal de grille, en général de l'aluminium, et à procéder à une découpe photolithographique classique de la grille métallique ce qui constitue le second niveau de masquage. Aux figures 6 et 7, qui représentent des vues de face et de dessus, on distingue la couche métallique 6 d'une épaisseur d'environ 0,2 $\mu$m déposée par évaporation. On distingue également un masque 7 de résine déposé sur la couche métallique 6. Ce masque va délimiter l'électrode de grille 61 du transistor. Celle-ci aura par exemple une forme en T dont la largeur L (de l'ordre de 2 à 10 $\mu$m) de la partie verticale déterminera la longueur du canal du transistor et dont la barre horizontale servira de prise de contact électrique. Les figures 8 et 9 qui représentent également des vues de face et de dessus, sont illustratives du dispositif obtenu à l'issue de la quatrième étape du procédé où l'électrode de grille 61 est recouverte du masque 7 qui a servi à la délimiter.

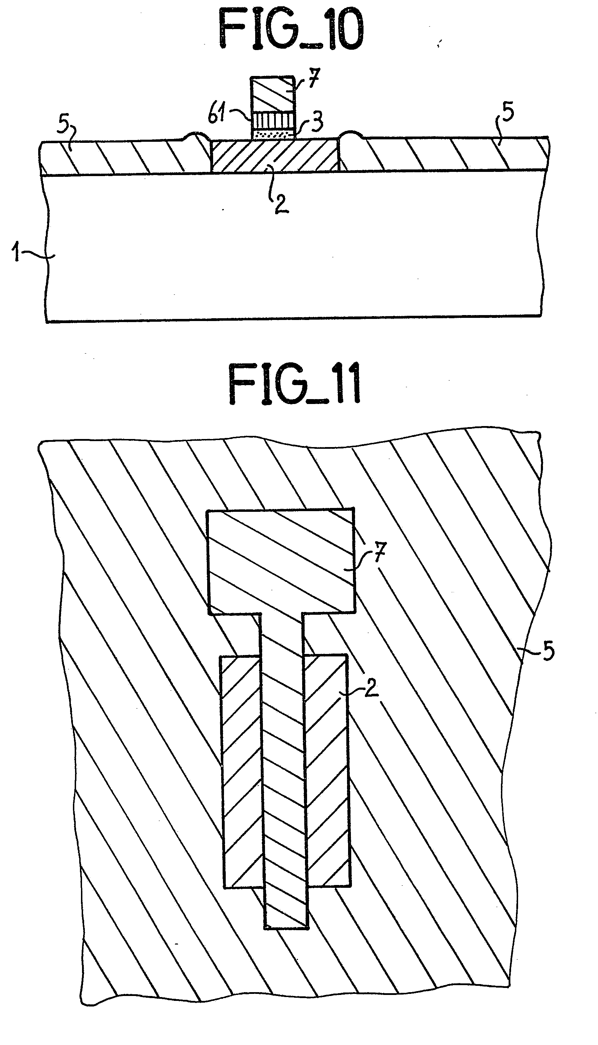

La cinquième étape consiste à attaquer, par voie chimique ou sèche, l'isolant de grille non situé directement sous l'électrode de grille 61 de façon à mettre à découvert les plages latérales de a -Si : H sur lesquelles seront formés les contacts source et drain. Dans cette étape, tout ou partie de l'isolant de passivation 5 non protégé par l'ensemble formé par l'électrode de grille 61 et la résine 7 peut être éliminé, l'isolement recherché sur les flancs de la mésa où déborde l'électrode de grille n'étant pas affecté par cette attaque. Du fait de la différence d'épaisseur entre les couches d'isolant 3 et 5, la seconde étant environ 5 fois plus épaisse que la première, il est possible de garder une épaisseur déterminée d'isolant de passivation. A l'issue de cette étape, le dispositif obtenu se présente sous la forme représentée à aux figures 10 et 11 qui sont respectivement une vue de face et une vue de dessus.

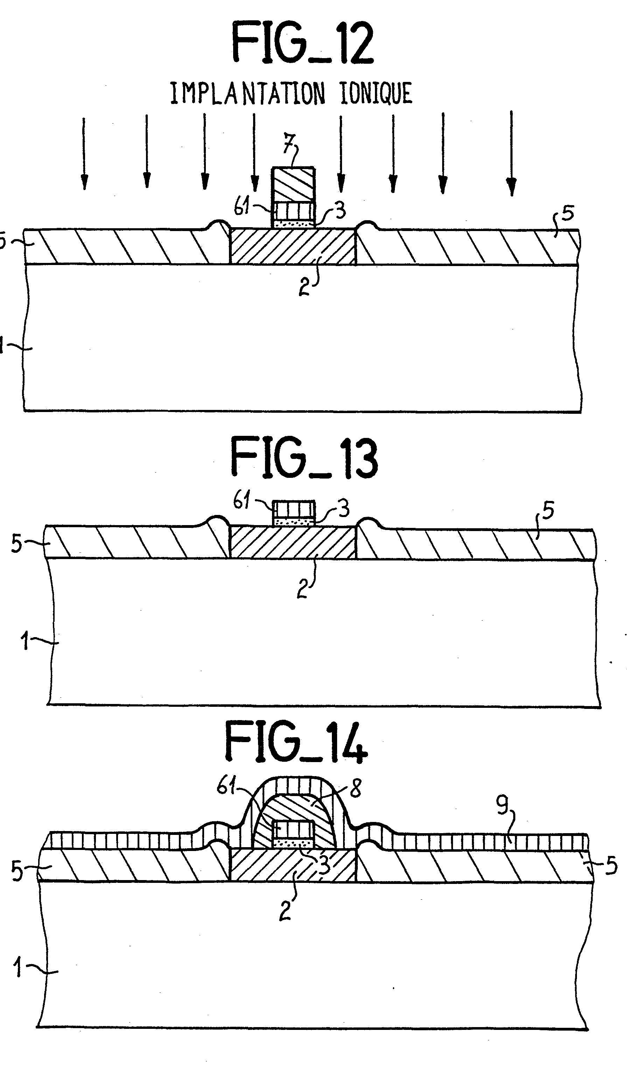

La sixième étape du procédé consiste en l'obtention de contacts ohmiques de source et de drain sur la couche de semiconducteur découverte. On emploie la technique d'implantation ionique à température ambiante. La figure 12 illustre cette étape du procédé. Les ions implantés sont par exemple : le phosphore ou l'arsenic pour disposer de contacts de type n, le bore pour disposer de contacts de type p. L'auto-alignement est obtenu par l'électrode de grille elle-même recouverte de résine. Cette couche de résine constitue une protection supplémentaire pour éviter la pénétration d'implants dans l'isolant de grille. Typiquement, les doses d'ions implantés sont de l'ordre de quelques $10^{16}/cm^2$ pour une énergie variant de 50 à 250 keV selon l'épaisseur de la couche de semiconducteur et dans le cas d'un contact n. Il est intéressant de procéder à une implantation à différents niveaux d'énergie afin d'optimiser la répartition des ions implantés en fonction des performances demandées aux transistors.

La septième étape du procédé consiste à éliminer la résine de protection de l'électrode de grille puis à faire une activation des implants. La résine est éliminée par voie chimique ou sèche. L'activation des implants est réalisée par un recuit sous un flux de gaz neutre à une température de l'ordre de 200 à 300° C, c'est-à-dire compatible avec la non-exodiffusion de l'hydrogène de la couche de a - Si : H. L'avantage de cette méthode est d'éviter la formation d'une résistance d'accès du canal du transistor. Cette étape est illustrée par la figure 13 qui représente le dispositif obtenu après l'élimination de la résine et activation des implants.

Il est aussi possible de réaliser la sixième étape à une température comprise entre 200 et 300° C et ainsi d'activer les impuretés dès leur implantation. Dans ce cas, la septième étape consiste à retirer la résine de la grille. Une attaque plasma sera nécessaire car la résine aura été recuite.

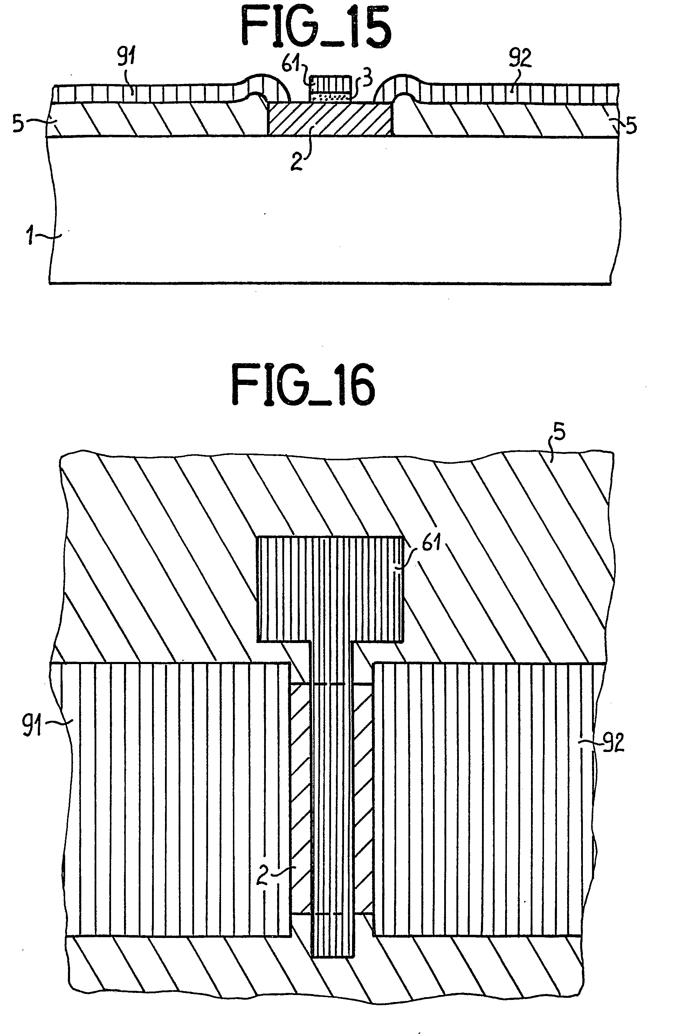

La huitième et dernière étape est constituée par l'élaboration des contacts métalliques source et drain sur le semiconducteur dopé. Ceci est obtenu par un troisième niveau de masquage et par la technique dite de lift-off. Les contacts métalliques seront en général en aluminium et déposés par évaporation. On peut encore les réaliser en chrome ou en un alliage de nickel et de chrome. Dans un tel procédé de réalisation, la longueur du canal est définie par la grille et la largeur par la mésa si bien que le positionnement de la source et du drain n'est pas très critique par rapport à la grille et la mésa. Le point sensible est d'éviter le court-circuit qui pourrait se produire entre l'électrode de grille et les électrodes de source et de drain. A cette fin, il est préférable de réserver une marge de sécurité déterminée entre ces contacts, typiquement de l'ordre de 5 à 10 $\mu$m. Cette distance est compatible avec une extension du procédé pour la réalisation de grandes surfaces, par exemple 20 cm sur 20 cm. Les figures 14, 15 et 16 sont illustratives de cette dernière étape du procédé. Par des techniques de masquage connues, on dépose des éléments de résine 8 sur chaque futur transistor. Chaque élément de résine 8 recouvre toutes les parties à ne pas métalliser, notamment : l'électrode de grille 61, la couche d'isolant de grille 3 sous-jacente et les parties de semiconducteur dopé à ne pas métalliser. La couche métallique 9 a une épaisseur sensiblement égale à 0,2 $\mu$m. Les figures 15 et 16 présentent une vue de face et une vue de dessus de la structure finale obtenue. L'opération de lift-off de la résine permet de donner au transistor sa structure finale en délimitant les électrodes de source 91 et de drain 92.

On peut remarquer que le procédé de fabrication selon l'invention conduit à une structure qui possède un canal dont la longueur est déterminée par la grille et dont la largeur est déterminée par la mésa.

Dans le cadre de la réalisation d'un écran de visualisation à accès matriciel, la couche métallique 9 peut, en plus de la formation des électrodes de source et de drain de chaque transistor, servir également à former des bandes conductrices d'accès soit aux électrodes sources, soit aux électrodes drain. Cet écran peut être utilisé en transmission puisque le substrat est transparent et que l'isolant de passivation, qui le recouvre en grande partie, l'est aussi de par ses propriétés optiques et sa faible épaisseur.

9

0165863

REVENDICATIONS

1. Procédé de fabrication d'au moins un transistor à effet de champ, en couche mince, de type coplanaire et à auto-alignement des électrodes, caractérisé en ce que le procédé comprend les huit étapes suivantes :

- première étape : dépôts successifs sur un substrat (1) d'une couche semiconductrice (2) et d'une couche d'isolant de grille (3),

- deuxième étape : formation de mésas par un premier jeu de masques de résine (4) et par attaque des couches d'isolant de grille (3) et semiconductrice (2) jusqu'au niveau du substrat (1), chacune des mésas étant destinée à la formation d'un transistor,

- troisième étape : dépôt d'une couche d'isolant de passivation (5) et mise à nu de l'isolant de grille (3) par retrait de la résine (4),

- quatrième étape : dépôt des électrodes de grille (61) des transistors par un deuxième jeu de masques de résine (7) et photolithographie,

- cinquième étape : attaque de la couche d'isolant de grille (3) non recouverte par les électrodes de grille (61) jusqu'à mise à nu de la couche semiconductrice (2),

- sixième étape : obtention de contacts ohmiques de source et de drain par implantation ionique,

- septième étape : élimination de la résine (7) de protection de grille suivie d'une activation des ions implantés à l'étape précédente,

- huitième étape : dépôt des électrodes de source (91) et de drain (92) par un troisième jeu de masques de résine (8) et retrait de la résine.

2. Procédé de fabrication selon la revendication 1, caractérisé en ce que, au cours de ladite première étape, les couches semiconductrices (2) et d'isolant de grille (3) sont déposées dans le même dispositif de dépôt et par la même méthode.

3. Procédé de fabrication selon la revendication 2, caractérisé en ce que ladite méthode de dépôt est une méthode de dépôt en phase gazeuse par décharge luminescente.

4. Procédé de fabrication selon l'une quelconque des revendications 1 à 3, caractérisé en ce que la couche semiconductrice (2) est une couche de silicium amorphe hydrogéné.

5. Procédé de fabrication selon l'une quelconque des revendications 1 à 4, caractérisé en ce que l'isolant de grille (3) est de l'oxyde de silicium, du nitrure de silicium ou de l'oxynitrure de silicium.

6. Procédé de fabrication selon l'une quelconque des revendications 1 à 5, caractérisé en ce que, les contacts ohmiques de source et de drain étant de type n, les ions implantés sont du phosphore ou de l'arsenic.

7. Procédé de fabrication selon l'une quelconque des revendications 1 à 5, caractérisé en ce que, les contacts ohmiques de source et de drain étant de type p, les ions implantés sont du bore.

8. Procédé de fabrication selon l'une quelconque des revendications 1 à 7, caractérisé en ce que l'implantation ionique de la sixième étape est réalisée à différents niveaux d'énergie afin d'optimiser la répartition des ions implantés.

9. Procédé de fabrication selon l'une quelconque des revendications 1 à 8, caractérisé en ce que les électrodes de grille (61), de source (91) et de drain (92) sont réalisés en un métal tel que l'aluminium ou le chrome ou en un alliage de nickel et de chrome.

10. Procédé de fabrication selon l'une quelconque des revendications 1 à 9, caractérisé en ce que les électrodes de grille (61), de source (91) et de drain (92) sont déposées par évaporation.

11. Procédé de fabrication selon l'une quelconque des revendications 1 à 10, caractérisé en ce que l'activation des ions implantés est réalisée par recuit sous un flux de gaz neutre.

12. Transistor à effet de champ, en couche mince, de type coplanaire et à électrodes auto-alignées (61, 91, 92) réalisé sur un substrat isolant (1), caractérisé en ce qu'il est obtenu par le procédé de fabrication selon l'une quelconque des revendications 1 à 11.

13. Transistor à effet de champ selon la revendication 12, caractérisé en ce que le substrat isolant (1) est transparent.

# FIG_1

# FIG_2

# FIG_3

# FIG_4

# FIG_5

# FIG_6

# FIG_7

# FIG_8

# FIG_9

# FIG_10

# FIG_11

# FIG_12

## IMPLANTATION IONIQUE

# FIG_13

# FIG_14

# FIG_15

91   61   3   92

5   5

2

1

# FIG_16

5

61

91   92

2

Office européen
des brevets

**RAPPORT DE RECHERCHE EUROPEENNE**

**0165863**
Numero de la demande

EP 85 40 1175

## DOCUMENTS CONSIDERES COMME PERTINENTS

| Catégorie | Citation du document avec indication. en cas de besoin. des parties pertinentes | Revendication concernée | CLASSEMENT DE LA DEMANDE (Int Cl 4) |
|---|---|---|---|
| A | EP-A-0 076 587 (XEROX CO.)<br><br>* Revendications 1-9; figures 1a-1j * | 1-3,5, 9,12 | H 01 L 21/84<br>H 01 L 29/78 |
| A | US-A-4 263 709 (C.E. WEITZEL et al.)<br>* En entier * | 1,3,5-7 | |
| A | US-A-4 242 156 (J.L. PEEL)<br><br>* En entier * | 1,5,12 ,13 | |
| A | US-A-4 422 090 (F.R. SHEPHERD et al.)<br>* Revendications 1-8; colonne 2, ligne 42 - colonne 3, ligne 3 * | 1,5,9, 12,13 | |
| A | IEEE TRANSACTIONS ON ELECTRON DEVICES, vol. ED-30, no. 5, mai 1983, pages 532-539, New York, US; D.G. AST: "Materials limitations of amorphous-Si:H transistors"<br>* Résumé * | 1,4 | DOMAINES TECHNIQUES RECHERCHES (Int. Cl.4)<br><br>H 01 L |
| A | EP-A-0 097 533 (FUJITSU LTD.)<br>* Résumé * | 1,8 | |

Le présent rapport de recherche a été établi pour toutes les revendications

| Lieu de la recherche | Date d'achèvement de la recherche | Examinateur |
|---|---|---|
| LA HAYE | 12-08-1985 | ZOLLFRANK G.O. |

OEB Form 1503. 03 82